# EUROPÄISCHE PATENTSCHRIFT

(11) **EP 2 417 346 B1**
(45) Veröffentlichungstag und Bekanntmachung des Hinweises auf die Patenterteilung: **21.11.2018**
(21) Anmeldenummer: 10704816.7
(22) Anmeldetag: 17.02.2010
(51) Int. Cl.: F02M 51/00, F02M 51/06, F02M 59/46, F02M 63/00, H01L 41/047, H01L 41/083

(54) **PIEZOELEKTRISCHER AKTOR UND BRENNSTOFFEINSPRITZVENTIL**
PIEZOELECTRIC ACTUATOR AND FUEL INJECTION VALVE
ACTIONNEUR PIÉZOÉLECTRIQUE ET SOUPAPE D'INJECTION DE COMBUSTIBLE

(30) Priorität: 09.04.2009 DE 102009002311
(43) Veröffentlichungstag der Anmeldung: 15.02.2012
(73) Patentinhaber: Robert Bosch GmbH, 70442 Stuttgart (DE)
(72) Erfinder: ESCHENBACHER, Cosima, 71701 Schwieberdingen (DE); MEYER, Andre, 71686 Remseck (DE); SPREMO, Ivan, 70197 Stuttgart (DE)
(86) Internationale Anmeldenummer: PCT/EP2010/051954
(87) Internationale Veröffentlichungsnummer: WO 2010/115652

(56) Entgegenhaltungen:
- FR-A1- 2 907 544
- US-A1- 2006 232 173

## Beschreibung

### Stand der Technik

Die Erfindung betrifft einen piezoelektrischen Aktor, insbesondere einen Aktor für Brennstoffeinspritzventile, und ein Brennstoffeinspritzventil mit einem piezoelektrischen Aktor. Speziell betrifft die Erfindung das Gebiet der Injektoren für Brennstoffeinspritzanlagen von luftverdichtenden, selbstzündenden Brennkraftmaschinen.

Aus der DE 102 17 361 A1 sind ein piezoelektrisches Element und eine damit versehene Einspritzdüse bekannt. Das bekannte piezoelektrische Element umfasst eine Keramikaufschichtung, die abwechselnd übereinander gestapelt mehrere Keramikschichten aus piezoelektrischer Keramik und mehrere Innenelektrodenschichten enthält. Ferner ist auf zumindest einem Teil der Oberfläche der Keramikaufschichtung mindestens eine organische Isolationsschicht aus organischem Material ausgebildet, und auf der organischen Isolationsschicht ist mindestens eine anorganische Isolationsschicht aus anorganischem Material ausgebildet. Die Keramikaufschichtung des piezoelektrischen Elements ist auf eine Weise gestaltet, bei der die Innenelektrodenschichten so ausgebildet sind, dass sie zwischen den Keramikschichten abwechselnd eine positive und eine negative Polarität annehmen. Dabei sind die positiven Innenelektrodenschichten in einer Position angeordnet, in der sie an einer Seitenfläche freiliegen, während die negativen Innenelektrodenschichten in einer Position angeordnet sind, in der sie an der anderen Seitenfläche der Keramikaufschichtung freiliegen. Die Seitenflächen der Keramikaufschichtung sind jeweils durch Einbrennen einer Silberpaste mit Seitenelektroden versehen, um die jeweils freiliegenden Endabschnitte der Innenelektrodenschichten elektrisch zu verbinden. Die Seitenelektroden sind unter Verwendung eines Epoxidharz und Silber enthaltenden leitenden Klebemittels mit externen Elektroden gekoppelt.

Zudem ist aus der US 2006/0232173 A1 ersichtlich, dass ein piezoelektrisches Element mit einer ersten Elektrodenschicht und einer zweiten Elektrodenschicht versehen und ein Anschlussdraht über die zweite Elektrodenschicht an die erste Elektrodenschicht angeschlossen ist. Das Dokument US 2006/0232173 A1 zeigt einen piezoelektrischen Aktor gemäß dem Oberbegriff des Anspruchs 1.

Das aus der DE 102 17 361 A1 bekannte piezoelektrische Element und die damit versehene Einspritzdüse haben den Nachteil, dass der aktuelle Betriebszustand des piezoelektrischen Elements nur ungefähr bekannt ist. Speziell kann es auf Grund äußerer Einflüsse im Betrieb, durch Fertigungstoleranzen oder durch eine Alterung zu Abweichungen im Betriebsverhalten kommen. Außerdem ist eine Anpassung an den Betriebszustand einer Brennkraftmaschine oder dergleichen in der Regel nicht möglich.

### Offenbarung der Erfindung

Der erfindungsgemäße piezoelektrische Aktor mit den Merkmalen des Anspruchs 1 und das erfindungsgemäße Brennstoffeinspritzventil mit den Merkmalen des Anspruchs 10 haben den Vorteil, dass eine zusätzliche Sensorfunktion integriert werden kann. Speziell besteht der Vorteil, dass die Integration einer Sensorfunktion in den piezoelektrischen Aktor oder das Brennstoffeinspritzventil keine oder nur geringfügige konstruktive Anpassungen erfordert.
Durch die in den Unteransprüchen aufgeführten Maßnahmen sind vorteilhafte Weiterbildungen des im Anspruch 1 angegebenen piezoelektrischen Aktors und des im Anspruch 10 angegebenen Brennstoffeinspritzventils möglich.
Vorteilhaft ist es, dass an der zweiten Seite des Aktorkörpers eine zweite Elektrodenanbindung zum Kontaktieren der in dem Aktorkörper an die zweite Seite geführten Elektrodenschichten vorgesehen ist, dass zumindest eine weitere elektrisch leitende Schicht als weitere Sensorschicht dient, dass die zweite Elektrodenanbindung im Bereich der Sensorschichten zumindest eine Aussparung aufweist und dass die weitere Sensorschicht durch eine Sensoranbindung kontaktiert ist, die in der Aussparung der zweiten Elektrodenanbindung an der zweiten Seite des Aktorkörpers angeordnet ist. Hierdurch kann eine Sensorfunktion durch zumindest zwei Sensorschichten in den piezoelektrischen Aktor integriert werden. Hierbei ist eine vorteilhafte Kontaktierung über die erste Seite und die zweite Seite des Aktorkörpers möglich. Dabei kann sowohl die Kontaktierung der Elektrodenschichten als auch die Kontaktierung der Sensorschichten an der ersten Seite und der zweiten Seite des Aktorkörpers erfolgen, wodurch sich eine kompakte Ausgestaltung ergibt.

Vorteilhaft ist es ferner, dass die Sensorschicht in dem Aktorkörper im Bereich der Aussparung der ersten Elektrodenanbindung bis an die erste Seite des Aktorkörpers geführt und von der zweiten Seite des Aktorkörpers beabstandet ist und dass die weitere Sensorschicht in dem Aktorkörper im Bereich der Aussparung der zweiten Elektrodenanbindung bis an die zweite Seite des Aktorkörpers geführt und von der ersten Seite des Aktorkörpers beabstandet ist. Durch diese Ausgestaltung der Sensorschichten, die durch den Produktionsprozess vorgegeben werden kann, wird in vorteilhafter Weise eine zuverlässige Kontaktierung der Sensorschichten mit den Sensoranbindungen ermöglicht.

Vorteilhaft ist es auch, dass die erste Elektrodenanbindung eine weitere Aussparung aufweist, dass die erste Elektrodenanbindung zwischen der Aussparung und der weiteren Aussparung einen stegförmigen Abschnitt aufweist, der sich an der ersten Seite des Aktorkörpers über die Sensorschichten erstreckt, und dass die Sensorschicht durch eine weitere Sensoranbindung kontaktiert ist, die in der weiteren Aussparung der ersten Elektrodenanbindung an der ersten Seite des Aktorkörpers angeordnet ist. Zusätzlich oder alternativ ist es auch von Vorteil, dass die zweite Elektrodenanbindung eine weitere Aussparung aufweist, dass die zweite Elektrodenanbindung zwischen der Aussparung und der weiteren Aussparung einen stegförmigen Abschnitt aufweist, der sich an der zweiten Seite des Aktorkörpers über die Sensorschichten erstreckt, und dass die weitere Sensorschicht durch eine weitere Sensoranbindung kontaktiert ist, die in der weiteren Aussparung der zweiten Elektrodenanbindung an der zweiten Seite des Aktorkörpers angeordnet ist. Auf diese Weise kann ein Sensorbereich, in dem die Sensorschichten angeordnet sind, durch die Elektrodenanbindungen überbrückt werden. Hierdurch vereinfacht sich auch die Verbindung von elektrischen Zuleitungen an die Elektrodenanbindungen. Beispielsweise können die elektrischen Zuleitungen pinförmig ausgestaltet sein. Entsprechend können auch Messleitungen vorgesehen sein, die zum Kontaktieren der Sensorschichten dienen. Solche Messleitungen können ebenfalls pinförmig ausgestaltet sein. Die pinförmigen elektrischen Zuleitungen und die pinförmigen Messleitungen können hierbei im Bereich der ersten Seite und der zweiten Seiten des Aktorkörpers jeweils nebeneinander die jeweilige Elektrodenanbindung beziehungsweise Sensoranbindung kontaktieren. Somit ist eine vorteilhafte elektrische Kontaktierung der elektrisch leitenden Schichten des piezoelektrischen Aktors mit vier oder mehr elektrischen Leitungen, insbesondere pinförmigen elektrischen Leitungen, möglich.

In vorteilhafter Weise ist die Sensorschicht in dem Bereich des stegförmigen Abschnitts der ersten Elektrodenanbindung von der ersten Seite des Aktorkörpers beabstandet. Ferner ist es vorteilhaft, dass die weitere Sensorschicht in dem Bereich des stegförmigen Abschnitts der zweiten Elektrodenanbindung von der zweiten Seite des Aktorkörpers beabstandet ist. Hierbei ist die Sensorschicht in dem Aktorkörper im Bereich der weiteren Aussparung der ersten Elektrodenanbindung vorzugsweise bis an die erste Seite des Aktorkörpers geführt und von der zweiten Seite des Aktorkörpers beabstandet, während die weitere Sensorschicht in dem Aktorkörper im Bereich der weiteren Aussparung der zweiten Elektrodenanbindung vorzugsweise bis an die zweite Seite des Aktorkörpers geführt und von der ersten Seite des Aktorkörpers beabstandet ist. Somit kann auf konstruktive Weise eine zuverlässige und selektive Anbindung an die Sensorschichten und die Elektrodenschichten des Aktorkörpers mittels der Sensoranbindungen und der Elektrodenanbindungen erfolgen. Hierbei weist die Elektrodenanbindung zum Ausgleichen eines während des Betriebs auftretenden Hubs des piezoelektrischen Aktorkörpers beispielsweise auf der ersten Seite und der zweiten Seite vorgesehene Grundmetallisierungen auf, auf denen jeweils Siebe der Elektrodenanbindungen aufgelötet sind. Eine solche Grundmetallisierung kann Silber und Palladium enthalten.

Die Sensorschichten sind vorzugsweise im Bereich eines an den Aktorkörper angefügten Aktorfußes angeordnet. Somit wirkt sich der Hub des Aktors im Betrieb in dem vorzugsweise relativ kurz gehaltenen Bereich der Sensorschichten nicht oder nur vernachlässigbar aus Hierdurch kann in vorteilhafter Weise eine Kontaktierung der Sensorschichten über auf der ersten Seite und der zweiten Seite vorgesehene, insbesondere aufgedruckte, Grundmetallisierungen erfolgen. Vorteilhaft ist es insbesondere, dass die Sensoranbindung eine elektrische Messleitung und eine in der Aussparung der ersten Elektrodenanbindung an der ersten Seite des Aktorkörpers vorgesehene Grundmetallisierung aufweist, über die die elektrische Messleitung der Sensoranbindung mit der Sensorschicht verbunden ist, und dass die weitere Sensoranbindung eine elektrische Messleitung und eine in der Aussparung der zweiten Elektrodenanbindung an der zweiten Seite des Aktorkörpers vorgesehene Grundmetallisierung aufweist, über die die elektrische Messleitung der weiteren Sensoranbindung mit der weiteren Sensorschicht verbunden ist. Hierdurch vereinfacht sich die Ausgestaltung der Sensoranbindungen. Insbesondere kann ein zusätzliches Sieb oder dergleichen als Bestandteil der Sensoranbindungen entfallen.

Hierbei ist es ferner vorteilhaft, dass mehrere Sensorschichten, insbesondere mehr als zwei Sensorschichten, vorgesehen sind, die abwechselnd mit der an der ersten Seite des Aktorkörpers vorgesehenen Sensoranbindung und der an der zweiten Seite des Aktorkörpers vorgesehenen Sensoranbindung kontaktiert sind. Hierdurch kann eine relativ große Messladung erzeugt werden, so dass das Messsignal über die Messleitungen zuverlässig zu einer Auswerteeinrichtung geführt werden kann. Ferner wird eine reproduzierbare Messspannung erzeugt, wobei Herstellungstoleranzen oder dergleichen durch die mehreren beteiligten piezoelektrischen Schichten im Hinblick auf die erzeugte Messspannung ausgeglichen werden.

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 ein Brennstoffeinspritzventil mit einem piezoelektrischen Aktor in einer schematischen, auszugsweisen Schnittdarstellung entsprechend einem ersten Ausführungsbeispiel der Erfindung;
Fig. 2 einen Schnitt durch den in Fig. 1 dargestellten piezoelektrischen Aktor entlang der mit II bezeichneten Schnittlinie entsprechend einer möglichen Ausgestaltung;
Fig. 3 einen Schnitt durch den in Fig. 1 dargestellten piezoelektrischen Aktor entlang der mit III bezeichneten Schnittlinie entsprechend einer möglichen Ausgestaltung;
Fig. 4 einen Schnitt durch den in Fig. 1 dargestellten piezoelektrischen Aktor entlang der mit IV bezeichneten Schnittlinie entsprechend dem ersten Ausführungsbeispiel der Erfindung;
Fig. 5 einen Schnitt durch den in Fig. 1 dargestellten piezoelektrischen Aktor entlang der mit V bezeichneten Schnittlinie entsprechend dem ersten Ausführungsbeispiel der Erfindung;
Fig. 6 ein Brennstoffeinspritzventil mit einem piezoelektrischen Aktor in einer schematischen, auszugsweisen Schnittdarstellung entsprechend einem zweiten Ausführungsbeispiel der Erfindung;
Fig. 7 einen Schnitt durch den in Fig. 6 dargestellten piezoelektrischen Aktor entlang der mit IV bezeichneten Schnittlinie entsprechend einem zweiten Ausführungsbeispiel und
Fig. 8 einen Schnitt durch den in Fig. 6 dargestellten piezoelektrischen Aktor entlang der mit V bezeichneten Schnittlinie entsprechend dem zweiten Ausführungsbeispiel der Erfindung.

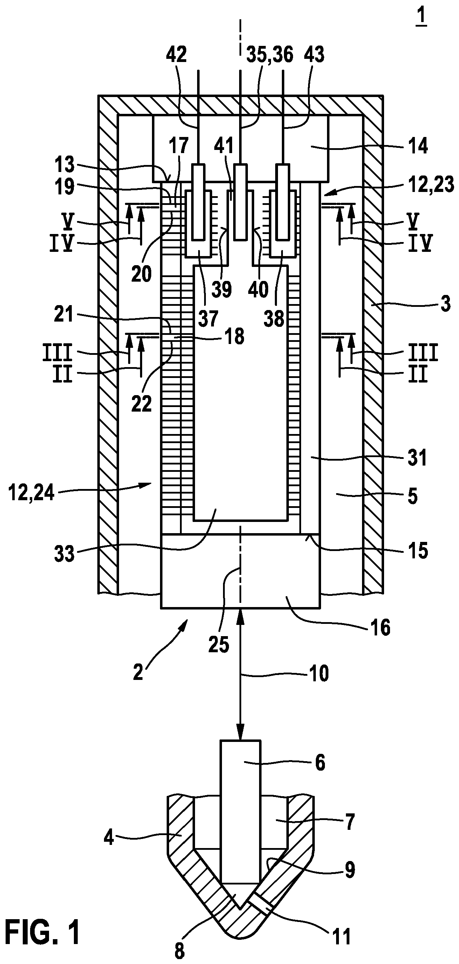

Fig. 1 zeigt ein Brennstoffeinspritzventil 1 mit einem piezoelektrischen Aktor 2 in einer auszugsweisen, schematischen Schnittdarstellung entsprechend einem ersten Ausführungsbeispiel- Das Brennstoffeinspritzventil 1 kann insbesondere als Injektor für Brennstoffeinspritzanlagen von luftverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Der piezoelektrische Aktor 2 eignet sich besonders für solch ein Brennstoffeinspritzventil 1. Das erfindungsgemäße Brennstoffeinspritzventil 1 und der erfindungsgemäße piezoelektrische Aktor 2 eignen sich jedoch auch für andere Anwendungsfälle.

Das Brennstoffeinspritzventil 1 weist ein Ventilgehäuse 3 und einen mit dem Ventilgehäuse 3 verbundenen Düsenkörper 4 auf. Der piezoelektrische Aktor 2 ist in einem Aktorraum 5 innerhalb des Ventilgehäuses 3 angeordnet. Außerdem ist eine Düsennadel 6 vorgesehen, die in einem Brennstoffraum 7 des Düsenkörpers 4 angeordnet ist. Die Düsennadel 6 weist einen Ventilschließkörper 8 auf, der mit einer Ventilsitzfläche 9, die an dem Düsenkörper 4 ausgebildet ist, zu einem Dichtsitz zusammenwirkt. Der piezoelektrische Aktor 2 steht mit der Düsennadel 6 in Wirkverbindung, wie es durch den Doppelpfeil 10 veranschaulicht ist.

In dem in der Fig. 1 dargestellten Ausgangszustand ist der zwischen dem Ventilschließkörper 8 und der Ventilsitzfläche 9 gebildete Dichtsitz geschlossen. Bei einer Betätigung der Düsennadel 6 mittels des Aktors 2 hebt sich der Ventilschließkörper 8 der Düsennadel 6 aus seinem Sitz, wodurch der zwischen dem Ventilschließkörper 8 und der Ventilsitzfläche 9 gebildete Dichtsitz geöffnet wird. Hierdurch kann Brennstoff aus dem Brennstoffraum 7 über den geöffneten Dichtsitz und eine Düsenöffnung 11 in einen Brennraum einer Brennkraftmaschine eingespritzt werden.

Der piezoelektrische Aktor 2 weist einen Aktorkörper 12, einen an eine Stirnfläche 13 des Aktorkörpers 12 angefügten Aktorfuß 14 und einen an eine weitere Stirnfläche 15 des Aktorkörpers 12, die von der Stirnfläche 13 abgewandt ist, angefügten Aktorkopf 16 auf. Über den Aktorfuß 14 stützt sich der Aktorkörper 12 an dem Ventilgehäuse 3 ab. Über den Aktorkopf 16 wirkt der Aktorkörper 12 auf die Düsennadel 6 ein.

Der Aktorkörper 12 weist eine Vielzahl von piezoelektrischen Schichten 17, 18 auf. Dabei sind in der Fig. 1 zur Vereinfachung der Darstellung nur die piezoelektrischen Schichten 17, 18 gekennzeichnet. Die piezoelektrischen Schichten 17, 18 können aus einem piezokeramischen oder elektroaktiven Material gebildet sein. Ferner weist der piezoelektrische Aktor 2 eine Vielzahl von elektrisch leitenden Schichten 19, 20, 21, 22 auf, wobei zur Vereinfachung der Darstellung nur die elektrisch leitenden Schichten 19 bis 22 gekennzeichnet sind. Hierbei sind die elektrisch leitenden Schichten 19 bis 22 zwischen den piezoelektrischen Schichten 17, 18 angeordnet. In diesem Ausführungsbeispiel ist dadurch die piezoelektrische Schicht 17 zwischen den elektrisch leitenden Schichten 19, 20 angeordnet, und die piezoelektrische Schicht 18 ist zwischen den elektrisch leitenden Schichten 21, 22 angeordnet. Die elektrisch leitenden Schichten 19, 20 dienen als Sensorschichten 19, 20. Die elektrisch leitenden Schichten 21, 22 dienen als Elektrodenschichten 21, 22. Durch die Sensorschichten 19, 20 und die zwischen den Sensorschichten 19, 20 angeordneten piezoelektrischen Schichten 17 ist ein Sensor 23 beziehungsweise ein Sensorbereich 23 in dem Aktorkörper 12 gebildet. Durch die Elektrodenschichten 21, 22 und die zwischen den Elektrodenschichten 21, 22 angeordneten piezoelektrischen Schichten 18 ist ein aktiver Bereich 24 des Aktorkörpers 12 gebildet. In diesem Ausführungsbeispiel ist der Aktorkörper 12 in den Sensorbereich 23 und den aktiven Bereich 24 entlang einer Längsachse 25 des Aktorkörpers 12 des Aktors 2 aufgeteilt. Der Sensorbereich 23 ist dabei in der Nähe des Aktorfußes 14 angeordnet. Insbesondere kann der Sensorbereich 23 direkt an die Stirnfläche 13 des Aktorkörpers 12 und somit den Aktorfuß 14 angrenzen. Der aktive Bereich 24 ist somit etwas von dem Aktorfuß 14 beabstandet, nämlich um die Länge des Sensorbereichs 23. Der aktive Bereich 24 grenzt in diesem Fall an die Stirnfläche 15 des Aktorkörpers 12 und somit an den Aktorkopf 16 an. Eine beim Laden und Entladen des Aktorkörpers 12 auftretende Dehnung und Kontraktion des Aktorkörpers 12 entlang seiner Längsachse 25 führt hierbei im Sensorbereich 23 zu einem relativ geringen Verstellweg. Der volle Hub des Aktorkörpers 12 besteht im Bereich der Stirnfläche 15 des Aktorkörpers 12.

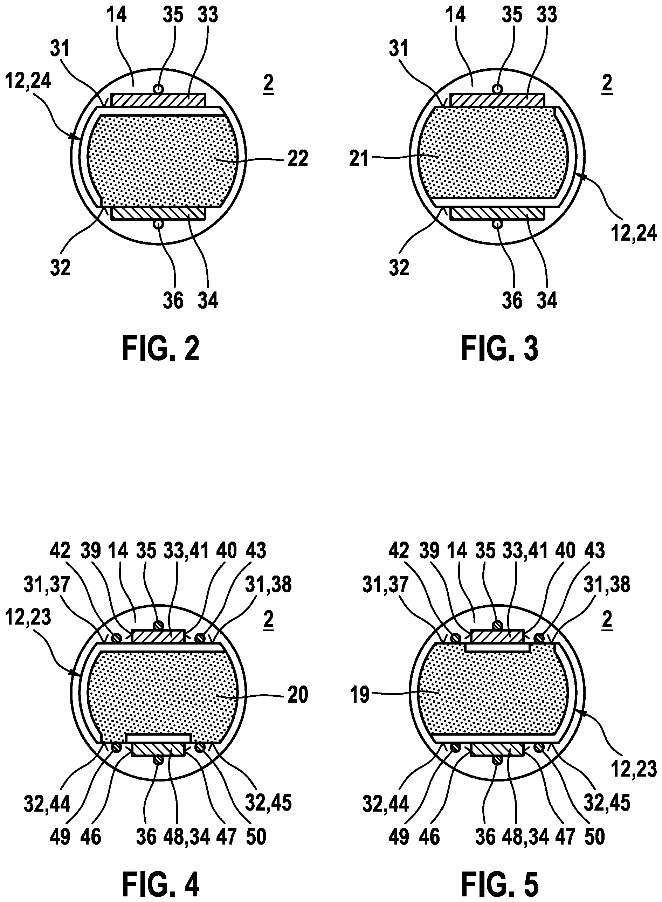

Der Aktorkörper 12 weist eine erste Seite 31 auf. Ferner weist der Aktorkörper 12 eine zweite Seite 32 (Fig. 2) auf, die von der ersten Seite 31 abgewandt ist. An der ersten Seite 31 des Aktorkörpers 12 ist eine erste Elektrodenanbindung 33 vorgesehen. Ferner ist an der zweiten Seite 32 eine zweite Elektrodenanbindung 34 (Fig. 2) vorgesehen. Die Elektrodenschichten 21, 22 des aktiven Bereichs 24 des Aktorkörpers 12 sind abwechselnd mit den Elektrodenanbindungen 33, 34 verbunden. Die Sensorschichten 19, 20 des Sensorbereichs 23 des Aktorkörpers 12 sind hingegen nicht mit den Elektrodenanbindungen 33, 34 verbunden. Die Verbindung der Elektrodenschichten 21, 22 kann mittels Grundmetallisierungen erfolgen, auf denen jeweils ein Sieb der Elektrodenanbindungen 33, 34 angebracht ist. Die Elektrodenanbindungen 33, 34 sind mit elektrischen Zuleitungen 35, 36 verbunden, die zumindest abschnittsweise pinförmig ausgestaltet sind. Die elektrischen Zuleitungen 35, 36 sind dabei durch das Ventilgehäuse 3 und den Aktorfuß 14 zu den Seiten 31, 32 des Aktorkörpers 12 geführt.

Ferner sind an der ersten Seite 31 des Aktorkörpers 12 Grundmetallisierungen 37, 38 vorgesehen. Hierbei weist die erste Elektrodenanbindung 33, die an der ersten Seite 31 vorgesehen ist, Aussparungen 39, 40 in dem Sensorbereich 23 auf. Das heißt, die erste Elektrodenanbindung 33 bedeckt nicht die gesamte erste Seite 31 des Aktorkörpers 12, sondern lässt auf Grund der Aussparungen 39, 40 im Sensorbereich 23 genügend Platz auf der ersten Seite 31, um zu ermöglichen, dass die Grundmetallisierungen 37, 38 zusätzlich zu der ersten Elektrodenanbindung 33 an der ersten Seite 31 vorgesehen sein können, wobei die Grundmetallisierungen 37, 38 von der ersten Elektrodenanbindung 33 elektrisch isoliert sind. Die elektrische Isolierung der Grundmetallisierungen 37, 38 von der ersten Elektrodenanbindung 33 erfolgt durch Freiräume, die auf Grund der Aussparungen 39, 40 der ersten Elektrodenanbindung 33 zu den Grundmetallisierungen 37, 38 gebildet sind.

Die Sensorschichten 19, 20 sind abwechselnd mit der Grundmetallisierung 37 verbunden. Beispielsweise kann die Sensorschicht 19 mit der Grundmetallisierung 37 verbunden sein, während die Sensorschicht 20 nicht mit der Grundmetallisierung 37 verbunden ist. Die Sensorschicht 19, die mit der Grundmetallisierung 37 verbunden ist, ist außerdem auch mit der Grundmetallisierung 38 verbunden. Die Sensorschicht 20, die nicht mit der Grundmetallisierung 37 verbunden ist, ist auch nicht mit der Grundmetallisierung 38 verbunden. Somit besteht hinsichtlich der Sensorschichten 19, 20 entweder eine Verbindung mit beiden Grundmetallisierungen 37, 38 oder überhaupt keine Verbindung mit den Grundmetallisierungen 37, 38. Die Sensorschichten 20, die nicht mit den Grundmetallisierungen 37, 38 verbunden sind, sind an der zweiten Seite 32 des Aktorkörpers 12 kontaktiert, wie es anhand der Fig. 5 in weiterem Detail beschrieben ist.

Die Ausgestaltung des Aktorkörpers 12, insbesondere der elektrisch leitenden Schichten 19 bis 22, ist im Folgenden auch unter Bezugnahme auf die Fig. 2 bis 5 in weiterem Detail beschrieben.

Fig. 2 zeigt einen schematischen Schnitt durch den in Fig. 1 dargestellten piezoelektrischen Aktor 2 des Brennstoffeinspritaventils 1 entlang der mit II bezeichneten Schnittlinie. An der ersten Seite 31 ist die erste Elektrodenanbindung 33 vorgesehen. Der mit II gekennzeichnete Schnitt durch den Aktorkörper 12 verläuft entlang der Elektrodenschicht 22. Die Elektrodenschicht 22 ist dabei so ausgestaltet, dass diese von der ersten Seite 31 beanstandet ist. Dadurch ist kein elektrischer Kontakt zwischen der ersten Elektrodenanbindung 33 und der Elektrodenschicht 22 gebildet. Die zweite Elektrodenanbindung 34 ist an der zweiten Seite 32 angeordnet.

Die Elektrodenschicht 22 erstreckt sich bis zu der zweiten Seite 32, so dass ein elektrischer Kontakt mit der zweiten Elektrodenanbindung 34 ermöglicht ist. Hierbei kann die zweite Elektrodenanbindung 34 ein Sieb aufweisen, dass mittels einer an der zweiten Seite 32 vorgesehenen Grundmetallisierung mit der Elektrodenschicht 22 verbunden ist.

Fig. 3 zeigt einen schematischen Schnitt durch den piezoelektrischen Aktor 2 entlang der mit III bezeichneten Schnittlinie. Die mit III gekennzeichnete Schnittlinie verläuft dabei entlang der Elektrodenschicht 21. Die Elektrodenschicht 21 ist bis an die erste Seite 31 geführt und von der zweiten Seite 32 beanstandet. Dadurch ist die Elektrodenschicht 21 mit der ersten Elektrodenanbindung 33 an der ersten Seite 31 elektrisch verbunden. Von der zweiten Elektrodenanbindung 34 ist die Elektrodenschicht 21 isoliert.

Entsprechend den in Fig. 2 und 3 gezeigten Elektrodenschichten 21, 22 sind die Elektrodenschichten des aktiven Bereichs 24 des Aktorkörpers 12 abwechselnd mit den Elektrodenanbindungen 33, 34 elektrisch kontaktiert. Über die elektrischen Zuleiten 35, 36, die mit den Elektrodenanbindungen 33, 34 verbunden sind, ist somit ein Laden und Entladen der zwischen den piezoelektrischen Schichten 18 vorgesehenen Elektrodenschichten 21, 22 des aktiven Bereichs 24 möglich.

Fig. 4 zeigt einen schematischen Schnitt durch den piezoelektrischen Aktor 2 des Brennstoffeinspritzventils 1 des ersten Ausführungsbeispiels entlang der mit IV bezeichneten Schnittlinie. Die mit IV bezeichnete Schnittlinie verläuft dabei entlang der Sensorschicht 20 durch den Aktorkörper 12. Die erste Elektrodenanbindung 33 an der ersten Seite 31 weist die Aussparungen 39, 40 auf, so dass ein stegförmiger Abschnitt 41 der ersten Elektrodenanbindung 33 gebildet ist. Die elektrische Zuleitung 35 ist an dem stegförmiger Abschnitt 41 mit der ersten Elektrodenanbindung 33 verbunden. Ferner sind an der ersten Seite 31 Grundmetallisierungen 37, 38 vorgesehen. Elektrische Messleitungen 42, 43, die zumindest abschnittsweise pinförmig ausgestaltet sind, sind durch den Aktorfuß 14 an den Aktorkörper 12 geführt. Die Messleitungen 42, 43 sind im Sensorbereich 33 mit den Grundmetallisierungen 37, 38 verbunden, um insbesondere einen elektrischen Kontakt mit der Sensorschicht 19 zu ermöglichen. Entsprechend sind Grundmetallisierungen 44, 45 an der zweiten Seite 32 des Aktorkörpers 12 im Sensorbereich 19, 20 vorgesehen. Hierbei weist die zweite Elektrodenanbindung 34 an der zweiten Seite 32 im Sensorbereich 23 Aussparungen 46, 47 auf, so dass ein stegförmiger Abschnitt 48 der zweiten Elektrodenanbindung 34 im Sensorbereich 23 gebildet ist. Die elektrische Zuleitung 36 ist an dem stegförmigen Abschnitt 48 mit der zweiten Elektrodenanbindung 34 verbunden. Ferner ist durch die Aussparungen 46, 47 im Sensorbereich 23 Platz gelassen, um die Grundmetallisierungen 44, 45 anzubringen. Ferner sind Messleitungen 49, 50 durch den Aktorfuß 14 zu dem Aktorkörper 12 im Sensorbereich 23 geführt. Die Messleitungen 49, 50 sind mit den Grundmetallisierungen 44, 45, die an der zweiten Seite 32 des Aktorkörpers 12 vorgesehen sind, verbunden. Über die Grundmetallisierungen 44, 45 ist eine elektrische Verbindung der Messleitungen 49, 50 mit der Sensorschicht 20 ausgebildet. Die Sensorschicht 20 ist hierbei im Bereich der Grundmetallisierungen 44, 45 bis an die zweite Seite 32 des Aktorkörpers 12 geführt. Allerdings ist die Sensorschicht 20 im Bereich des stegförmigen Abschnitts 48 zu der zweiten Seite 32 hin etwas ausgespart und somit zu der zweiten Seite 32 beabstandet, um einen elektrischen Kontakt mit der zweiten Elektrodenanbindung 34 zu verhindern.

Fig. 5 zeigt einen schematischen Schnitt durch den piezoelektrischen Aktor 2 des Brennstoffeinspritzventils 1 des ersten Ausführungsbeispiels entlang der mit V bezeichneten Schnittlinie. Die mit V bezeichnete Schnittlinie verläuft dabei entlang der Sensorschicht 19. Die Sensorschicht 19 ist an die erste Seite 31 des Aktorkörpers 12 geführt. Hierbei ist die Sensorschicht 19 im Bereich der Grundmetallisierungen 37, 38 bis an die erste Seite 31 geführt, aber im Bereich der ersten Elektrodenanbindung 33 von der ersten Seite 31 etwas beabstandet.

Dadurch ist ein elektrischer Kontakt der Sensorschicht 19 mit den Messleitungen 42, 43 gewährleistet, während die Sensorschicht 19 von dem streifenförmigen Abschnitt 41 der ersten Elektrodenanbindung 33 isoliert ist. Ferner ist die Sensorschicht 19 von der zweiten Seite 32 beabstandet. Somit ist die Sensorschicht 19 sowohl von dem streifenförmigen Abschnitt 48 der zweiten Elektrodenanbindung 34 als auch von den Messleitungen 49, 50 elektrisch isoliert.

Somit ist anhand der Fig. 4 und 5 verdeutlicht, wie die Sensorschichten 19, 20 über die Grundmetallisierungen 37, 38, 44, 45 mit den Messleitungen 42, 43, 49, 50 verbunden sind, wobei die Sensorschicht 19 mit den Messleitungen 42, 43 verbunden ist und die Sensorschicht 20 mit den Messleitungen 49, 50 verbunden ist. Entsprechend sind alle elektrisch leitenden Schichten 19, 20, die im Sensorbereich 23 des Aktorkörpers 12 vorgesehen sind und somit als Sensorschichten 19, 20 dienen, abwechselnd mit dem Messleitungspaar 42, 43 und dem Messleitungspaar 49, 50 verbunden. Hierbei ist ein geringerer Übergangswiderstand und eine gewisse Redundanz durch die paarweise Kontaktierung mit dem Messleitungspaar 42, 43 beziehungsweise dem Messleitungspaar 49, 50 ermöglicht.

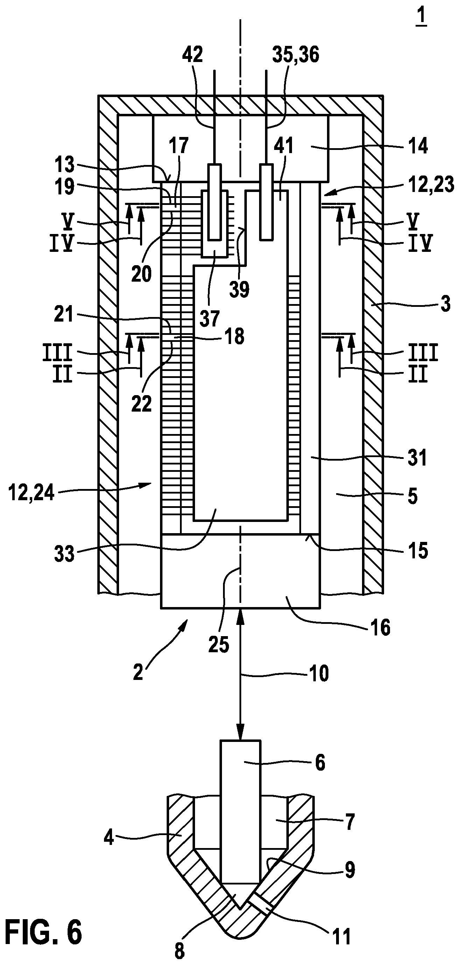

Fig. 6 zeigt ein Brennstoffeinspritzventil 1 mit einem piezoelektrischen Aktor 2 entsprechend einem zweiten Ausführungsbeispiel der Erfindung. In diesem Ausführungsbeispiel weist die an der ersten Seite 31 vorgesehene erste Elektrodenanbindung 33 nur eine Aussparung 39 auf, wodurch der streifenförmige Abschnitt 41 gebildet ist.

Die Aussparung 39 lässt hierbei Platz für die Grundmetallisierung 37, wobei die Grundmetallisierung 37 von der ersten Elektrodenanbindung 33 isoliert ist. Die elektrische Messleitung 42 ist beispielsweise mit der Sensorschicht 19 elektrisch verbunden. Die der Sensorschicht 19 entsprechenden Sensorschichten des Sensorbereichs 23 sind somit in diesem Ausführungsbeispiel über nur eine Grundmetallisierung 37 mit der einen Messleitung 42 elektrisch verbunden.

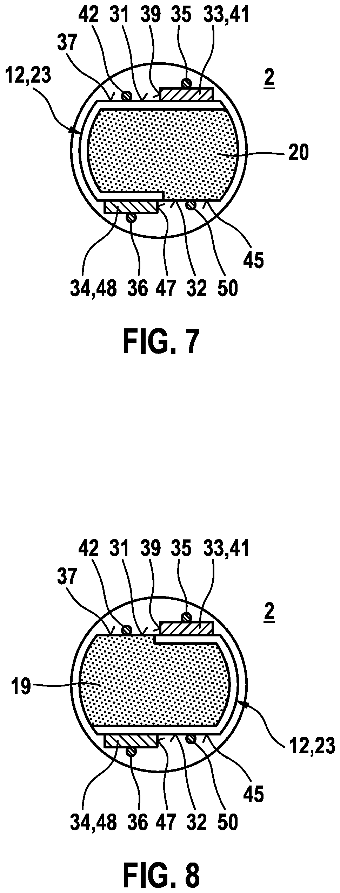

Die Ausgestaltung des piezoelektrischen Aktors 2 des Brennstoffeinspritzventils 1 ist im Folgenden auch unter Bezugnahme auf die Fig. 7 und 8 im weiteren Detail beschrieben.

Fig. 7 zeigt einen schematischen Schnitt durch den in Fig. 6 dargestellten piezoelektrischen Aktor 2 des Brennstoffeinspritzventils 1 des zweiten Ausführungsbeispiels entlang der mit IV bezeichneten Schnittlinie. Entsprechend der Aussparung 39 der ersten Elektrodenanbindung 33 weist auch die zweite Elektrodenanbindung 34 an der zweiten Seite 32 eine Aussparung 47 auf. Durch die Aussparung 47 ist Raum für die Grundmetallisierung 45 an der zweiten Seite 32 gelassen. Die zweite Elektrodenanbindung 34 ist hierbei im Sensorbereich 23 in Form des stegförmigen Abschnitts 48 ausgestaltet. Die Messleitung 50 ist mit der Grundmetallisierung 45 verbunden. Die Sensorschicht 20 ist an die zweite Seite 32 geführt, nämlich im Bereich der Grundmetallisierung 45. Hierbei ist die Sensorschicht 20 allerdings im Bereich des stegförmigen Abschnitts 48 der zweiten Elektrodenanbindung 34 etwas von der zweiten Seite 32 beabstandet, so dass die Sensorschicht 20 von der zweiten Elektrodenanbindung 34 elektrisch isoliert ist. Ferner ist die Sensorschicht 20 von der ersten Seite 31 beabstandet, so dass die Sensorschicht 20 sowohl gegenüber der Messleitung 42 als auch gegenüber der ersten Elektrodenanbindung 33 elektrisch isoliert ist.

Fig. 8 zeigt einen schematischen Schnitt durch den piezoelektrischen Aktor 2 des Brennstoffeinspritzventils 1 entsprechend dem zweiten Ausführungsbeispiel entlang der mit V bezeichneten Schnittlinie. Hierbei verläuft der mit V gekennzeichnete Schnitt durch den piezoelektrischen Aktor 2 entlang der Sensorschicht 19. Die Sensorschicht 19 ist bis zu der ersten Seite 31 geführt, aber von der zweiten Seite 32 beabstandet Hierbei ist die Sensorschicht 19 im Bereich der Grundmetallisierung 37 bis an die erste Seite 31 geführt, aber im Bereich des stegförmigen Abschnitts 41 der ersten Elektrodenanbindung 33 von der ersten Seite 31 etwas beabstandet. Somit ist die Sensorschicht 19 elektrisch mit der Messleitung 42 verbunden.

Somit ist anhand der Fig. 7 und 8 veranschaulicht, wie die Sensorschichten 19, 20 des Sensorbereichs 23 abwechselnd mit den Messleitungen 42, 50 elektrisch verbunden sind.

Die Elektrodenschichten 21, 22 des aktiven Bereichs 24 des Aktorkörpers 12 des piezoelektrischen Aktors 2 des zweiten Ausführungsbeispiels sind entsprechend den Elektroderschichten 21, 22 des piezoelektrischen Aktors 2 des in Fig. 1 dargestellten Brennstoffeinspritzventils 1 des ersten Ausführungsbeispiels ausgestaltet. Die mit II und III bezeichneten Schnitte durch den piezoelektrischen Aktor 2 des zweiten Ausführungsbeispiels entsprechen somit abgesehen von der Position der elektrischen Zuleitungen 35, 36 den in Fig. 2 und 3 gezeigten Schnitten des ersten Ausführungsbeispiels.

Die Erfindung ist nicht auf die beschriebenen Ausführungsbeispiele beschränkt.

## Patentansprüche

1. Piezoelektrischer Aktor (2), insbesondere Aktor für Brennstoffeinspritzventile, mit einem Aktorkörper (12), der eine Vielzahl von piezoelektrischen Schichten (17, 18) und eine Vielzahl von zwischen den piezoelektrischen Schichten (17, 18) angeordneten elektrisch leitenden Schichten (19, 20 21, 22) aufweist, wobei mehrere der elektrisch leitenden Schichten (19, 20, 21, 22) als Elektrodenschichten (21, 22) dienen, die in dem Aktorkörper (12) abwechselnd an eine erste Seite (31) und an eine zweite Seite (32) des Aktorkörpers (12) geführt sind, wobei an der ersten Seite (31) des Aktorkörpers (12) eine erste Elektrodenanbindung (33) zum Kontaktieren der in dem Aktorkörper (12) an die erste Seite (31) geführten Elektrodenschichten (21) vorgesehen ist, **dadurch gekennzeichnet, dass** zumindest eine der elektrisch leitenden Schichten (19, 20, 21, 22) als Sensorschicht (19, 20) dient, wobei die Sensorschicht (19, 20) durch eine elektrisch von der ersten Elektrodenanbindung (33) isolierte Sensoranbindung (37) kontaktiert ist, und wobei die erste Elektrodenanbindung (33) im Bereich der Sensorschicht (19, 20) zumindest eine Aussparung (39) aufweist in der die Sensoranbindung (37) an der ersten Seite (31) des Aktorkörpers (12) angeordnet ist

2. Piezoelektrischer Aktor nach Anspruch 1, **dadurch gekennzeichnet, dass** an der zweiten Seite (32) des Aktorkörpers (12) eine zweite Elektrodenanbindung (34) zum Kontaktieren der in dem Aktorkörper (12) an die zweite Seite (32) geführten Elektrodenschichten (22) vorgesehen ist, dass zumindest eine weitere elektrisch leitende Schicht (20) als weitere Sensorschicht (20) dient, dass die zweite Elektrodenanbindung (34) im Bereich (23) der Sensorschichten (19, 20) zumindest eine Aussparung (47) aufweist und dass die weitere Sensorschicht (20) durch eine Sensoranbindung (45) kontaktiert ist, die in der Aussparung (47) der zweiten Elektrodenanbindung (34) an der zweiten Seite (32) des Aktorkörpers (12) angeordnet ist.

3. Piezoelektrischer Aktor nach Anspruch 2, **dadurch gekennzeichnet, dass** die Sensorschicht (19) in dem Aktorkörper (12) im Bereich der Aussparung (39) der ersten Elektrodenanbindung (33) bis an die erste Seite (31) des Aktorkörpers (12) geführt und von der zweiten Seite (32) des Aktorkörpers (12) beabstandet ist und dass die weitere Sensorschicht (20) in dem Aktorkörper (12) im Bereich der Aussparung (47) der zweiten Elektrodenanbindung (34) bis an die zweite Seite (32) des Aktorkörpers (12) geführt und von der ersten Seite (31) des Aktorkörpers (12) beabstandet ist.

4. Piezoelektrischer Aktor nach Anspruch 2 oder 3, **dadurch gekennzeichnet, dass** die erste Elektrodenanbindung (33) eine weitere Aussparung (40) aufweist, dass die erste Elektrodenanbindung (33) zwischen der Aussparung (39) und der weiteren Aussparung (40) einen stegförmigen Abschnitt (41) aufweist, der sich an der ersten Seite (31) des Aktorkörpers (12) über die Sensorschichten (19, 20) erstreckt, und dass die Sensorschicht (19) durch eine weitere Sensoranbindung (38) kontaktiert ist, die in der weiteren Aussparung (40) der ersten Elektrodenanbindung (33) an der ersten Seite (31) des Aktorkörpers (12) angeordnet ist, und/oder dass die zweite Elektrodenanbindung (34) eine weitere Aussparung (46) aufweist, dass die zweite Elektrodenanbindung (34) zwischen der Aussparung (47) und der weiteren Aussparung (46) einen stegförmigen Abschnitt (48) aufweist, der sich an der zweiten Seite (32) des Aktorkörpers (12) über die Sensorschichten (19, 20) erstreckt, und dass die weitere Sensorschicht (20) durch eine weitere Sensoranbindung (44) kontaktiert ist, die in der weiteren Aussparung (46) der zweiten Elektrodenanbindung (34) an der zweiten Seite (32) des Aktorkörpers (12) angeordnet ist.

5. Piezoelektrischer Aktor nach Anspruch 4, **dadurch gekennzeichnet, dass** die Sensorschicht (19) in dem Aktorkörper (12) im Bereich der weiteren Aussparung (40) der ersten Elektrodenanbindung (33) bis an die erste Seite (31) des Aktorkörpers (12) geführt und von der zweiten Seite (32) des Aktorkörpers (12) beabstandet ist und dass die weitere Sensorschicht (20) in dem Aktorkörper (12) im Bereich der weiteren Aussparung (46) der zweiten Elektrodenanbindung (34) bis an die zweite Seite (32) des Aktorkörpers (12) geführt und von der ersten Seite (31) des Aktorkörpers (12) beabstandet ist.

6. Piezoelektrischer Aktor nach Anspruch 4 oder 5, **dadurch gekennzeichnet, dass** die Sensorschicht (19) im Bereich des stegförmigen Abschnitts (41) der ersten Elektrodenanbindung (33) von der ersten Seite (31) des Aktorkörpers (12) beabstandet ist und dass die weitere Sensorschicht (20) in dem Bereich des stegförmigen Abschnitts (48) der zweiten Elektrodenanbindung (34) von der zweiten Seite (32) des Aktorkörpers (12) beabstandet ist.

7. Piezoelektrischer Aktor nach einem der Ansprüche 2 bis 6, **dadurch gekennzeichnet, dass** die Sensoranbindung eine elektrische Messleitung (42) und eine in der Aussparung (39) der ersten Elektrodenanbindung (33) an der ersten Seite (31) des Aktorkörpers (12) vorgesehene Grundmetallisierung (37) aufweist, über die die elektrische Messleitung (42) der Sensoranbindung mit der Sensorschicht (19) verbunden ist, und dass die weitere Sensoranbindung eine elektrische Messleitung (50) und eine in der Aussparung (47) der zweiten Elektrodenanbindung (34) an der zweiten Seite (32) des Aktorkörpers (12) vorgesehene Grundmetallisierung (45) aufweist, über die die elektrische Messleitung (50) der weiteren Sensoranbindung mit der weiteren Sensorschicht (20) verbunden ist.

8. Piezoelektrischer Aktor nach einem der Ansprüche 2 bis 7, **dadurch gekennzeichnet, dass** mehrere Sensorschichten (19, 20) vorgesehen sind, die abwechselnd mit der an der ersten Seite (31) des Aktorkörpers (12) vorgesehenen Sensoranbindung (37) und der an der zweiten Seite (32) des Aktorkörpers (12) vorgesehenen Sensoranbindung (45) kontaktiert sind.

9. Piezoelektrischer Aktor nach einem der Ansprüche 2 bis 8, **dadurch gekennzeichnet, dass** die Sensorschichten (19, 20) im Bereich (23) eines an den Aktorkörper (12) angefügten Aktorfußes (14) angeordnet sind

10. Brennstoffeinspritzventil (1), insbesondere Injektor für Brennstoffeinspritzanlagen von luftverdichtenden, selbstzündenden Brennkraftmaschinen, mit einem piezoelektrischen Aktor (2) nach einem der Ansprüche 1 bis 9 und einem von dem Aktor (2) betätigbaren Ventilschließkörper (8), der mit einer Ventilsitzfläche (9) zu einem Dichtsitz zusammenwirkt.

## Claims

1. Piezoelectric actuator (2), in particular actuator for fuel injection valves, comprising an actuator body (12) having a multiplicity of piezoelectric layers (17, 18) and a multiplicity of electrically conductive layers (19, 20, 21, 22) arranged between the piezoelectric layers (17, 18), wherein a plurality of the electrically conductive layers (19, 20, 21, 22) serve as electrode layers (21, 22) which are led in the actuator body (12) alternately to a first side (31) and to a second side (32) of the actuator body (12), wherein at the first side (31) of the actuator body (12) provision is made of a first electrode link (33) for contacting the electrode layers (21) led to the first side (31) in the actuator body (12), **characterized in that** at least one of the electrically conductive layers (19, 20, 21, 22) serves as sensor layer (19, 20), wherein the sensor layer (19, 20) is contacted by a sensor link (37), which is electrically insulated from the first electrode link (33), and wherein the first electrode link (33) has in the region of the sensor layer (19, 20) at least one cutout (39) in which the sensor link (37) is arranged at the first side (31) of the actuator body (12).

2. Piezoelectric actuator according to Claim 1, **characterized in that** at the second side (32) of the actuator body (12) provision is made of a second electrode link (34) for contacting the electrode layers (22) led to the second side (32) in the actuator body (12), **in that** at least one further electrically conductive layer (20) serves as further sensor layer (20), **in that** the second electrode link (34) has at least one cutout (47) in the region (23) of the sensor layers (19, 20), and **in that** the further sensor layer (20) is contacted by a sensor link (45) arranged in the cutout (47) of the second electrode link (34) at the second side (32) of the actuator body (12).

3. Piezoelectric actuator according to Claim 2, **characterized in that** the sensor layer (19) is led in the actuator body (12) in the region of the cutout (39) of the first electrode link (33) as far as the first side (31) of the actuator body (12) and is at a distance from the second side (32) of the actuator body (12), and **in that** the further sensor layer (20) is led in the actuator body (12) in the region of the cutout (47) of the second electrode link (34) as far as the second side (32) of the actuator body (12) and is at a distance from the first side (31) of the actuator body (12).

4. Piezoelectric actuator according to Claim 2 or 3, **characterized in that** the first electrode link (33) has a further cutout (40), **in that** the first electrode link (33) has a web-shaped section (41) between the cutout (39) and the further cutout (40), said section extending at the first side (31) of the actuator body (12) above the sensor layers (19, 20), and **in that** the sensor layer (19) is contacted by a further sensor link (38) arranged in the further cutout (40) of the first electrode link (33) at the first side (31) of the actuator body (12), and/or **in that** the second electrode link (34) has a further cutout (46), **in that** the second electrode link (34) has a web-shaped section (48) between the cutout (47) and the further cutout (46), said section extending at the second side (32) of the actuator body (12) above the sensor layers (19, 20), and **in that** the further sensor layer (20) is contacted by a further sensor link (44) arranged in the further cutout (46) of the second electrode link (34) at the second side (32) of the actuator body (12).

5. Piezoelectric actuator according to Claim 4, **characterized in that** the sensor layer (19) is led in the actuator body (12) in the region of the further cutout (40) of the first electrode link (33) as far as the first side (31) of the actuator body (12) and is at a distance from the second side (32) of the actuator body (12), and **in that** the further sensor layer (20) is led in the actuator body (12) in the region of the further cutout (46) of the second electrode link (34) as far as the second side (32) of the actuator body (12) and is at a distance from the first side (31) of the actuator body (12) .

6. Piezoelectric actuator according to Claim 4 or 5, **characterized in that** the sensor layer (19) is at a distance from the first side (31) of the actuator body (12) in the region of the web-shaped section (41) of the first electrode link (33), and **in that** the further sensor layer (20) is at a distance from the second side (32) of the actuator body (12) in the region of the web-shaped section (48) of the second electrode link (34).

7. Piezoelectric actuator according to any of Claims 2 to 6, **characterized in that** the sensor link has an electrical measurement line (42) and a basic metalization (37) provided in the cutout (39) of the first electrode link (33) at the first side (31) of the actuator body (12), via which basic metalization the electrical measurement line (42) of the sensor link is connected to the sensor layer (19), and **in that** the further sensor link has an electrical measurement line (50) and a basic metalization (45) provided in the cutout (47) of the second electrode link (34) at the second side (32) of the actuator body (12), via which basic metalization the electrical measurement line (50) of the further sensor link is connected to the further sensor layer (20).

8. Piezoelectric actuator according to any of Claims 2 to 7, **characterized in that** a plurality of sensor layers (19, 20) are provided which are contacted alternately with the sensor link (37) provided at the first side (31) of the actuator body (12) and the sensor link (45) provided at the second side (32) of the actuator body (12).

9. Piezoelectric actuator according to any of Claims 2 to 8, **characterized in that** the sensor layers (19, 20) are arranged in the region (23) of an actuator base (14) attached to the actuator body (12).

10. Fuel injection valve (1), in particular injector for fuel injection systems of air-compressing, auto-ignition internal combustion engines, comprising a piezoelectric actuator (2) according to any of Claims 1 to 9 and a valve closing body (8), which is actuatable by the actuator (2) and which cooperates with a valve seat surface (9) to form a sealing seat.

## Revendications

1. Actionneur piézoélectrique (2), en particulier actionneur pour soupapes d'injection de carburant, présentant un corps d'actionneur (12) doté de plusieurs couches piézoélectriques (17, 18) et de plusieurs couches électriquement conductrices (19, 20, 21, 22) disposées entre les couches piézoélectriques (17, 18),
plusieurs des couches électriquement conductrices (19, 20, 21, 22) servant de couches d'électrode (21, 22) placées dans le corps d'actionneur (12) en alternance sur un premier côté (31) et un deuxième côté (32) du corps d'actionneur (12),
un premier raccordement d'électrode (33) qui assure le contact des couches d'électrode (21) placées dans le corps d'actionneur (12) sur le premier côté (31) étant prévu sur le premier côté (31) du corps d'actionneur (12),
**caractérisé en ce qu'**au moins l'une des couches électriquement conductrices (19, 20, 21, 22) sert de couche de capteur (19, 20), la couche de capteur (19, 20) étant mise en contact par un raccordement de capteur (37) isolé du premier raccordement d'électrode (33), le premier raccordement d'électrode (33) présentant au niveau de la couche de capteur (19, 20) au moins une découpe (39) dans laquelle le raccordement de capteur (37) est disposé sur le premier côté (31) du corps d'actionneur (12).

2. Actionneur piézoélectrique selon la revendication 1, **caractérisé en ce que** sur le deuxième côté (32) du corps d'actionneur (12) est prévu un deuxième raccordement d'électrode (34) qui assure le contact des couches d'électrode (22) dans le corps d'actionneur (12) placées sur le deuxième côté (32), **en ce qu'**au moins une autre couche électriquement conductrice (20) sert d'autre couche de capteur (20), **en ce que** le deuxième raccordement d'électrode (34) présente au moins une découpe (47) au niveau (23) des couches de capteurs (19, 20) et **en ce que** l'autre couche de capteur (20) est mise en contact par un raccordement de capteur (45) disposé dans la découpe (47) de la deuxième raccordement d'électrode (34) sur le deuxième côté (32) du corps d'actionneur (12).

3. Actionneur piézoélectrique selon la revendication 2, **caractérisé en ce que** la couche de capteur (19) est amenée dans le corps d'actionneur (12) au niveau de la découpe (39) du premier raccordement d'électrode (33) jusqu'au premier côté (31) du corps d'actionneur (12) et est maintenue à distance du deuxième côté (32) du corps d'actionneur (12) et **en ce que** l'autre couche de capteur (20) est amenée dans le corps d'actionneur (12) au niveau de la découpe (47) du deuxième raccordement d'électrode (34) jusqu'au deuxième côté (32) du corps d'actionneur (12) et est maintenue à distance du premier côté (31) du corps d'actionneur (12).

4. Actionneur piézoélectrique selon les revendications 2 ou 3, **caractérisé en ce que** le premier raccordement d'électrode (33) présente une autre découpe (40), **en ce que** le premier raccordement d'électrode (33) présente entre la découpe (39) et la découpe (40) une section (41) en forme de nervure qui s'étend sur le premier côté (31) du corps d'actionneur (12) au-dessus des couches de capteur (19, 20) et **en ce que** la couche de capteur (19) est mise en contact par un autre raccordement de capteur (38) qui est disposé dans la découpe (40) du premier raccordement d'électrode (33), sur le premier côté (31) du corps d'actionneur (12), et/ou **en ce que** le deuxième raccordement d'électrode (34) présente une autre découpe (46), et **en ce que** le deuxième raccordement d'électrode (34) présente entre la découpe (47) et l'autre découpe (46) une section (48) en forme de nervure qui s'étend sur le deuxième côté (32) du corps d'actionneur (12) au-dessus des couches de capteurs (19, 20) et **en ce que** l'autre couche de capteur (20) est mise en contact par un autre raccordement de capteur (44) qui est disposé dans la découpe (46) du deuxième raccordement d'électrode (34), sur le deuxième côté (32) du corps d'actionneur (12).

5. Actionneur piézoélectrique selon la revendication 4, **caractérisé en ce que** la couche de capteur (19) est amenée dans le corps d'actionneur (12) au niveau de la découpe (40) du premier raccordement d'électrode (33) jusqu'au premier côté (31) du corps d'actionneur (12) et est maintenue à distance du deuxième côté (32) du corps d'actionneur (12) et **en ce que** l'autre couche de capteur (20) est amenée dans le corps d'actionneur (12) au niveau de la découpe (46) du deuxième raccordement d'électrode (34) jusqu'au deuxième côté (32) du corps d'actionneur (12) et est maintenue à distance du premier côté (31) du corps d'actionneur (12).

6. Actionneur piézoélectrique selon les revendications 4 ou 5, **caractérisé en ce qu'**au niveau de la section (41) en forme de nervure, du premier raccordement d'électrode (33), la couche de capteur (19) est maintenue à distance du premier côté (31) du corps d'actionneur (12) et **en ce qu'**au niveau de la section (48) en forme de nervure du deuxième raccordement d'électrode (34), l'autre couche de capteur (20) est maintenue à distance du deuxième côté (32) du corps d'actionneur (12).

7. Actionneur piézoélectrique selon l'une des revendications 2 à 6, **caractérisé en ce que** le raccordement de capteurs présente un conducteur électrique de mesure (42) et une métallisation de fond (37) prévue dans la découpe (39) du premier raccordement d'électrode (33) sur le premier côté (31) du corps d'actionneur (12), par laquelle le conducteur électrique de mesure (42) du raccordement de capteurs est raccordé à la couche de capteur (19) et **en ce que** l'autre raccordement de capteur présente un conducteur électrique de mesure (50) et une métallisation de base (45) prévue dans la découpe (47) du deuxième raccordement d'électrode (34) sur le deuxième côté (32) du corps d'actionneur (12), par laquelle le conducteur électrique de mesure (50) de l'autre raccordement de capteurs est raccordé à l'autre couche de capteur (20).

8. Actionneur piézoélectrique selon l'une des revendications 2 à 7, **caractérisé en ce que** plusieurs couches de capteur (19, 20) sont prévues et sont mises en contact en alternance avec le raccordement de capteur (37) prévu sur le premier côté (31) du corps d'actionneur (12) et avec le raccordement de capteur (45) prévu sur le deuxième côté (32) du corps d'actionneur (12).

9. Actionneur piézoélectrique selon l'une des revendications 2 à 8, **caractérisé en ce que** les couches de capteur (19, 20) sont disposées au niveau (23) d'un pied d'actionnement (14) relié au corps d'actionneur (12) .

10. Soupape (1) d'injection de carburant, en particulier injecteur pour installation d'injection de carburant de moteurs à combustion interne à autoallumage et compression d'air, présentant un actionneur piézoélectrique (2) selon l'une des revendications 1 à 9 et un corps (8) de fermeture de soupape actionné par l'actionneur (2) et coopérant avec une surface (9) de siège de soupape pour former un siège étanche.
